# FASCICULE DE BREVET EUROPEEN

(11) **EP 2 999 001 B1**
(45) Date de publication et mention de la délivrance du brevet: **04.09.2019**
(21) Numéro de dépôt: 15184982.5
(22) Date de dépôt: 14.09.2015
(51) Int. Cl.: H01L 29/78, H01L 21/336

(54) **RÉALISATION D'ESPACEURS AU NIVEAU DE FLANCS D'UNE GRILLE DE TRANSISTOR**
EINBRINGUNG VON ABSTANDHALTERN AN DEN SEITEN EINES TRANSISTOR-GATES
PRODUCTION OF SPACERS AT THE EDGES OF A TRANSISTOR GATE

(30) Priorité: 17.09.2014 FR 1458759
(43) Date de publication de la demande: 23.03.2016
(73) Titulaire: COMMISSARIAT À L'ÉNERGIE ATOMIQUE ET AUX ÉNERGIES ALTERNATIVES, 75015 Paris (FR); STmicroelectronics SA, 92120 Montrouge (FR); STMicroelectronics (Crolles 2) SAS, 38920 Crolles (FR)
(72) Inventeur: ARVET, Christian, 38190 BERNIN (FR); BARNOLA, Sébastien, 38190 VILLARD-BONNOT (FR); LAGRASTA, Sébastien, 38330 MONTBONNOT SAINT MARTIN (FR); POSSEME, Nicolas, 38000 GRENOBLE (FR)
(74) Mandataire: Decobert, Jean-Pascal

(56) Documents cités:
- US-A1- 2002 063 299
- US-A1- 2004 132 258
- US-A1- 2013 164 940
- US-B1- 6 232 641
- US-B1- 6 635 938
- VINET M ET AL: "Enabling the use of ion implantation for ultra-thin FDSOI n-MOSFETs", VLSI TECHNOLOGY, SYSTEMS, AND APPLICATIONS (VLSI-TSA), 2012 INTERNATIONAL SYMPOSIUM ON, IEEE, 23 avril 2012 (2012-04-23), pages 1-2, XP032448888, DOI: 10.1109/VLSI-TSA.2012.6210170 ISBN: 978-1-4577-2083-3

## Description

### DOMAINE TECHNIQUE DE L'INVENTION

La présente invention concerne les transistors, particulièrement les transistors du type MOS (Métal Oxyde Semi-Conducteur) et plus particulièrement la réalisation des espaceurs de grille de tels transistors.

L'industrie de la microélectronique, qui s'entend ici comme incluant la nanotechnologie, est concernée par l'invention, dans l'emploi de transistors à effet de champs et notamment de transistors MOSFET largement employés dans les circuits intégrés.

### ETAT DE LA TECHNIQUE

Un exemple de technique de réalisation des zones de source et de drain de tels transistors est donné par la publication WO-A1-0229881. Ce document montre aussi un cas de fabrication d'espaceurs de grille.

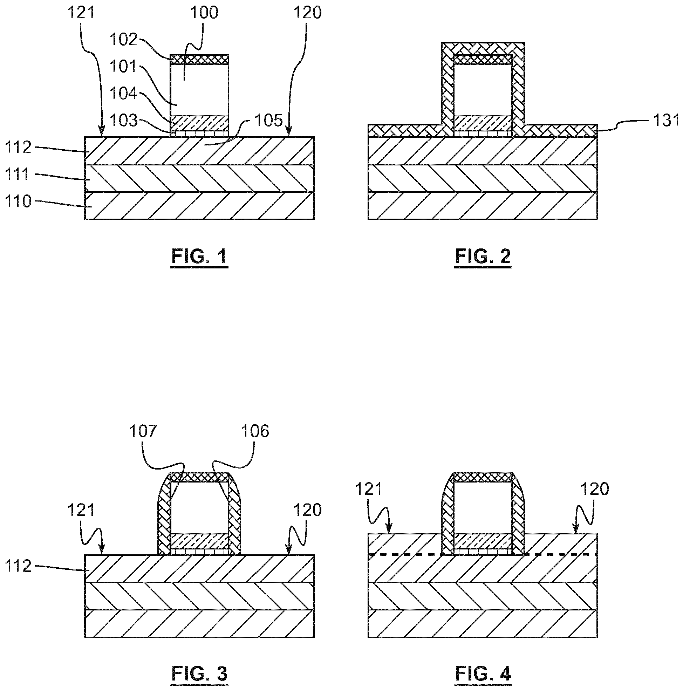

La figure 1 est une vue en coupe d'un exemple de ce type de transistor en cours de réalisation. On y retrouve les zones de source et de drain 120, 121. La grille 100 est classiquement constituée d'un empilement de couches dont une grande partie est toujours constituée de silicium polycristallin 101. La formation des zones de source et drain 120, 121 se fait typiquement par implantation ionique de dopants dans les zones 120, 121, la grille 100 servant de masque comme mentionné ci-dessus, empêchant ainsi le dopage de la zone du transistor dans laquelle, en fonction des tensions appliquées sur la grille 100, va pouvoir se développer le canal 105 de conduction entre source et drain.

La technique de base, très brièvement décrite ci-dessus, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique utilisée actuellement consiste à fabriquer les circuits intégrés en partant de substrats élaborés de type silicium sur isolant, désignés par leur acronyme SOI, de l'anglais « silicon on insulator ». Le substrat élaboré SOI est caractérisé par la présence d'une fine couche superficielle de silicium monocristallin, de Germanium ou de Silicium-Germanium 112 reposant sur une couche continue isolante d'oxyde 111 en particulier de silicium, dit oxyde enterré ou encore BOX acronyme de l'anglais « buried oxide layer ». La couche 111 repose sur la couche 110 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 111. Les couches 103 et 104 constituent l'oxyde de grille comprenant le plus souvent dans les réalisations récentes une couche 104 d'un matériau à haute permittivité relative dit « high-k ». La couche 102 est un masque dur servant à protéger, à ce stade de réalisation, l'empilement des couches de grille sous-jacentes. La couche superficielle 112 par exemple en silicium monocristallin peut être contrôlée précisément en épaisseur et en dopage. En particulier, il est avantageux pour les performances des transistors que le canal 105 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 112 est très mince. Ce type de transistor est ainsi désigné par l'acronyme FDSOI.

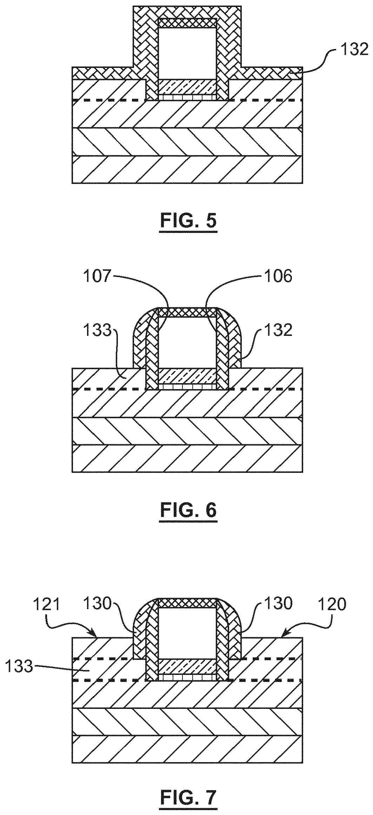

Un perfectionnement de la technique de base d'auto-alignement qui a été universellement adopté consiste en la formation d'espaceurs 130 sur les flancs de la grille 100. Les espaceurs 130, typiquement faits de nitrure de silicium (SiN), vont permettre en particulier la mise en oeuvre d'une technique dite de « Source et Drain surélevés » dont un résultat intermédiaire est visible en figure 4. Il est devenu courant que l'on pratique ces opérations deux fois de suite afin d'obtenir le résultat final qui est illustré en figure 7 où l'on peut distinguer deux niveaux d'espaceurs ainsi que les deux niveaux correspondants de surélévation des zones de source et drain. Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 120, 121. Au cours de cette opération on va faire croître localement la couche surfacique 112 initiale de silicium monocristallin. Il faut alors protéger les zones de grilles pour empêcher la croissance de se faire également à partir du silicium polycristallin 101 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 130 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs 130 se fait dans cette technologie sans faire intervenir aucune opération de photogravure.

Pour y parvenir, la figure 2 montre la formation d'une première couche de nitrure 131, en particulier du nitrure de silicium (SᵢN). Cette couche est ensuite soumise, à l'étape de la figure 3, à une gravure fortement anisotrope de sorte que la gravure supprime les parties de la couche 131 situées sur la couche surfacique 112 (qui sont généralement horizontales, c'est-à-dire orientées perpendiculairement à l'épaisseur du substrat 110) tout en préservant, au moins en partie, le nitrure sur les parties non horizontales et particulièrement sur les parties formant les flancs (106, 107 de la grille 100).

On obtient ainsi un premier niveau d'espaceurs constitués par les parties résiduelles faites de nitrure couvrant les flancs 106, 107.

Après un nettoyage par voie humide, on procède, comme en figure 4, à une première étape de croissance des sources et drains par épitaxie au niveau des zones 120, 121.

On réalise alors des espaceurs de deuxième niveau. A cet effet, une nouvelle couche de nitrure 132 est déposée, comme le montre la figure 5.

De façon similaire au cas de la figure 3, la figure 6 illustre une gravure de la couche de nitrure 132 telle que la couche 132 n'est préservée, au moins en partie, que sur les flancs de la grille, en recouvrant les espaceurs déjà formés à ce niveau. Globalement, ces étapes conduisent à des espaceurs dont le pied présente un retrait 133.

Une nouvelle phase d'épitaxie est alors produite de sorte que les zones de source/drain 120, 121 croissent autour de la grille 100, celle-ci étant protégée par les espaceurs 130 comme présenté en figure 7.

La technologie ainsi décrite se révèle complexe, surtout par le nombre d'étapes mises en oeuvre. D'une manière générale, et ce même pour la réalisation d'espaceurs d'un seul niveau, les techniques actuelles ne permettent pas de contrôler précisément les phases de gravure et donc la forme finale des parties constitutives du transistor, notamment la forme de la base des espaceurs.

Le document US-A1-20040132258 divulgue la formation, au niveau de flancs de grille de transistor, de deux couches d'espaceurs. Les deux couches sont ensuite gravées simultanément au-dessus du substrat pour ne garder en place que les parties verticales.

Le document US-B1-6635938 prévoit lui aussi deux couches d'espaceurs dont les parties horizontales sont retirées simultanément pour ne garder en place que la partie verticale autour des flancs de grille.

Le document US-B1-6232641, le document US-A1-20130164940 et le document US-A1-20020063299 prévoient des dépôts successifs d'une couche diélectrique et d'une couche superficielle sur un ensemble composé d'un substrat et d'une grille de transistor, une gravure partielle de la couche superficielle de sorte à conserver la couche superficielle uniquement sur les flancs de la grille de transistor, puis la gravure de la couche diélectrique à l'aplomb du substrat, de sorte à former des espaceurs au niveau des flancs de la grille de transistor.

La présente invention permet de répondre à au moins une partie des inconvénients des techniques actuelles.

### RESUME DE L'INVENTION

Un aspect de l'invention est relatif à un procédé de réalisation d'espaceurs au niveau de flancs d'une grille de transistor dans lequel la grille est située au-dessus d'une couche d'un matériau semi-conducteur. De manière avantageuse le procédé comprend successivement les étapes suivantes :
- formation d'une couche diélectrique qui recouvre la grille et au moins une zone périphérique de la couche de matériau semi-conducteur entourant la grille ;
- gravure anisotrope de la couche diélectrique configurée pour enlever partiellement la couche diélectrique au niveau de la zone périphérique tout en préservant la couche diélectrique au niveau des flancs ;
- puis, après la gravure anisotrope, formation d'une couche superficielle recouvrant la couche diélectrique ;
- gravure partielle de la couche superficielle configurée pour enlever totalement la couche superficielle au niveau de la zone périphérique tout en préservant une partie résiduelle de la couche superficielle au niveau des flancs ; cette gravure préserve au moins en partie la couche diélectrique au niveau de la zone périphérique ;
- puis, après la gravure partielle, gravure de la couche diélectrique de manière sélective par rapport à la partie résiduelle de la couche superficielle et par rapport à la couche de matériau semi-conducteur.

Ainsi, lors de la phase de gravure permettant d'enlever le matériau de la couche diélectrique au-dessus des zones autour de la grille (c'est-à-dire à l'endroit des zones source/drain), la partie de cette couche qui est au niveau des flancs de grille est protégée par la couche superficielle qui subsiste à cet endroit. On peut donc plus librement régler les paramètres de la gravure finale, qui est une gravure sélective relativement à la couche superficielle, de sorte à maîtriser, par exemple, la forme à donner au pied des espaceurs, ou encore pour éviter une attaque du matériau de la couche surfacique, par exemple en silicium nanocristallin (mais aussi possiblement en Germanium ou en Silicium-Germanium).

Relativement à l'art antérieur connu de US-A1-20040132258 et de US-B1-6635938, l'invention combat un même préjugé qui consiste à réaliser l'enlèvement simultané de la couche superficielle et de la couche diélectrique par simplicité en termes de process de fabrication. La gravure s'opère au contraire en deux temps par l'invention, avec la gravure partielle, et, après son achèvement, une gravure de la couche diélectrique. A priori moins optimale, cette façon de procéder permet au contraire de produire des gravures bien sélectives relativement à l'environnement des couches à enlever. En particulier, la couche diélectrique est enlevée, grâce à l'invention, sans endommager la couche de matériau semi-conducteur sous-jacente. Ce résultat est impossible avec les techniques existantes. L'invention est ainsi compatible avec des technologies dans lesquelles l'épaisseur de la couche semi-conductrice est faible, par exemple moins de 5nm, et le procédé peut être appliqué à des substrats du type Silicium sur isolant (SOI), dont FDSOI (pour Fully Depleted Silicon on Insulator).

Suivant un mode de réalisation, la formation de la couche superficielle comprend une modification du matériau d'une partie seulement de l'épaisseur de la couche diélectrique. Il n'est donc pas forcément requis de procéder à une étape de dépôt pour réaliser la couche superficielle. On peut en particulier procéder à une oxydation du matériau de la couche diélectrique, particulièrement si elle est à base de ou faite de nitrure, tel du nitrure de silicium. A ce sujet, on notera que l'oxydation peut être réalisée par plasma dans des conditions isotropes ou quasi isotropes de sorte que la couche oxydée est conforme. Dans le même temps, éventuellement dans le même réacteur, on peut procéder à une gravure moins isotrope (et en pratique fortement anisotrope) de sorte à n'enlever totalement la couche oxydée qu'aux endroits désirés (c'est-à-dire hors des zones de flancs de la grille).

Suivant certains aspects de modes de réalisation de l'invention, toutes les étapes ou au moins certaines étapes successives peuvent être réalisées au sein d'un même réacteur. L'emploi de la technologie plasma permet donc d'éviter des manipulations.

On notera par ailleurs que l'on peut obtenir, lorsque cela est désiré des espaceurs dont le pied comporte un retrait, sans avoir recours à deux séries phases de dépôt et de gravure de couches de nitrure comme dans l'état de la technique.

L'invention est aussi relative, dans des modes de réalisation, à la fabrication d'un transistor à structure source/drain surélevée dans lequel une grille et des zones de source et de drain sont situées au-dessus d'une couche d'un matériau semi-conducteur, et qui comporte des espaceurs au niveau des flancs de la grille configurés pour isoler la grille des zones de source et de drain. Ce transistor est préférentiellement tel que les espaceurs présentent une couche unique d'un matériau diélectrique, de préférence du nitrure de silicium. En complément ou alternativement, le transistor peut comprendre des parties de couverture au moins partielle de la couche unique des espaceurs, de préférence en un oxyde du matériau diélectrique de la couche unique.

Suivant une possibilité complémentaire ou alternative non limitative, les zones de source et de drain sont situées dans une couche unique d'un matériau, ladite couche unique étant située au-dessus de la couche d'un matériau semi-conducteur.

Suivant une autre possibilité non limitative les espaceurs comportent une zone de pied au-dessus de la couche de matériau semi-conducteur, la zone de pied comportant un retrait en direction du flanc de la grille, de sorte à former un décrochement.

Un autre aspect de l'invention est la fabrication d'un transistor, tel un transistor MOS, dans lequel les espaceurs de grille sont partiellement recouverts d'une couche superficielle d'un matériau différent du matériau des espaceurs, par exemple un oxyde du matériau des espaceurs. Un tel transistor peut être obtenu par le procédé de l'invention.

Un autre aspect de l'invention concerne un procédé de réalisation d'un transistor dans lequel la grille est située au-dessus d'une couche d'un matériau semi-conducteur, ledit procédé comprenant la réalisation d'espaceurs suivant le procédé de réalisation d'espaceurs de l'invention. Il peut comprendre la réalisation de zones de source et de drain avec une croissance par épitaxie sur la couche de matériau semi-conducteur.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
- les figures 1 à 7 illustrent des phases successives de réalisation d'espaceurs sur deux niveaux et de source/drain autour d'une grille de transistor, selon l'état de la technique, les espaceurs à deux niveaux ayant une forme telle que leur pied présente un retrait vers la grille.
- La figure 8 présente une configuration possible de grille et de substrat au départ du procédé de l'invention.
- Les figures 9 à 14 montrent des étapes de l'invention.
- La figure 15 illustre l'étape d'épitaxie unique du procédé de l'invention au cours de laquelle on réalise les zones de source et drain surélevées.
- la figure 16a présente un cas non désiré de forme de pied d'espaceur que l'on constate après gravure de la couche de nitrure de silicium selon les techniques existantes. La figure 16b montre un autre cas non désiré où la couche servant à la croissance épitaxiale des source et drain est attaquée.
- La figure 17 illustre l'absence des défauts mentionnés dans les deux figures précédentes lorsque l'on utilise le procédé de l'invention.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DETAILLEE DE L'INVENTION

Avant d'entrer dans le détail de mode de réalisation de l'invention, notamment en référence aux dessins, des caractéristiques non limitatives que l'invention peut présenter individuellement ou selon toutes combinaisons sont introduites brièvement ci-après :
- la formation de la couche superficielle comprend une modification du matériau d'une partie seulement de l'épaisseur de la couche diélectrique ;
- la modification est une oxydation ;
- l'oxydation est réalisée de manière conforme au niveau des flancs et de la zone périphérique ;
- l'oxydation est réalisée à partir d'un plasma ;
- on utilise un plasma d'oxygène dans lequel l'énergie des ions est comprise entre 8 et 13 eV, de préférence 10 eV ;
- la formation de la couche superficielle comprend un dépôt d'une couche de matériau au-dessus de la couche diélectrique ;
- le matériau de la couche de matériau au-dessus de la couche diélectrique est choisi parmi un matériau comprenant du carbone, un oxyde tel du dioxyde de Silicium (SiO2), un matériau contenant du Germanium et notamment du Silicium Germanium ou du nitrure de Silicium Germanium, avec de préférence un taux de germanium de 15 à 40%.
- l'enlèvement partiel de la couche superficielle est une gravure opérée à partir d'un plasma ;
- la gravure de l'enlèvement partiel de la couche superficielle est une gravure anisotrope configurée pour attaquer la couche superficielle au niveau de la zone périphérique tout en n'attaquant pas ou en attaquant moins la couche superficielle au niveau de la grille ;
- la gravure anisotrope est réalisée avec un plasma d'argon ou de tétrafluorure de carbone dans lequel l'énergie des ions est comprise entre 8 et 13 eV, de préférence 10 eV ;
- la gravure sélective est opérée à partir d'un plasma ;
- on opère la gravure anisotrope puis la gravure sélective dans un même réacteur ;
- la gravure sélective est opérée par voie humide ;
- la gravure sélective est configurée pour attaquer partiellement la couche diélectrique dans une zone de pied de grille située en dessous de la partie résiduelle en direction du flanc de la grille de sorte à former un retrait;
- le retrait a une hauteur comprise entre 5 et 30 nm, et de préférence entre 10 et 15 nm ;
- le retrait a une largeur comprise entre 5 et 10 nm et/ou a une largeur de grandeur inférieure celle de la hauteur du retrait ;
- la gravure sélective est configurée pour former un bord droit dans la couche diélectrique suivant l'épaisseur de la couche diélectrique en alignement avec la partie résiduelle
- la couche diélectrique est faite par une couche de nitrure, de préférence de nitrure de silicium ;
- la couche diélectrique est faite en un matériau low-k de constante diélectrique plus faible que celle du nitrure de silicium ;
- on utilise comme couche d'un matériau semi-conducteur une couche superficielle d'une plaque de silicium sur isolant totalement déplétée (FD-SOI).

Il est précisé que dans le cadre de la présente invention, le terme « sur », « surmonte » ou « sous-jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Dans ce qui suit, on entend par gravure sélective l'enlèvement par gravure d'un matériau donné en préservant au moins en partie, par la sélectivité du procédé employé, d'autres matériaux.

Les termes « couche superficielle » correspondent à une couche qui est formée, en particulier par modification de la couche sous-jacente ou par un dépôt sur cette couche-sous-jacente, en surface du dispositif électronique après la formation de la couche sous-jacente. Elle est ensuite partiellement retirée pour retirer en partie la couche-sous-jacente. L'adjectif « superficielle » ne signifie pas obligatoirement que la couche superficielle résiduelle reste toujours en surface du dispositif lorsque la fabrication de ce dernier est finalisée. Elle peut être par exemple enlevée ou recouverte.

On entend par « conforme » une géométrie de couche qui présente une même épaisseur, aux tolérances de fabrication près, une épaisseur identique malgré les changements de direction de couche, par exemple au niveau de flancs de motif de grille.

Le mot « diélectrique » correspond à un matériau dont la conductivité électrique est suffisamment faible dans l'application donnée pour servir d'isolant.

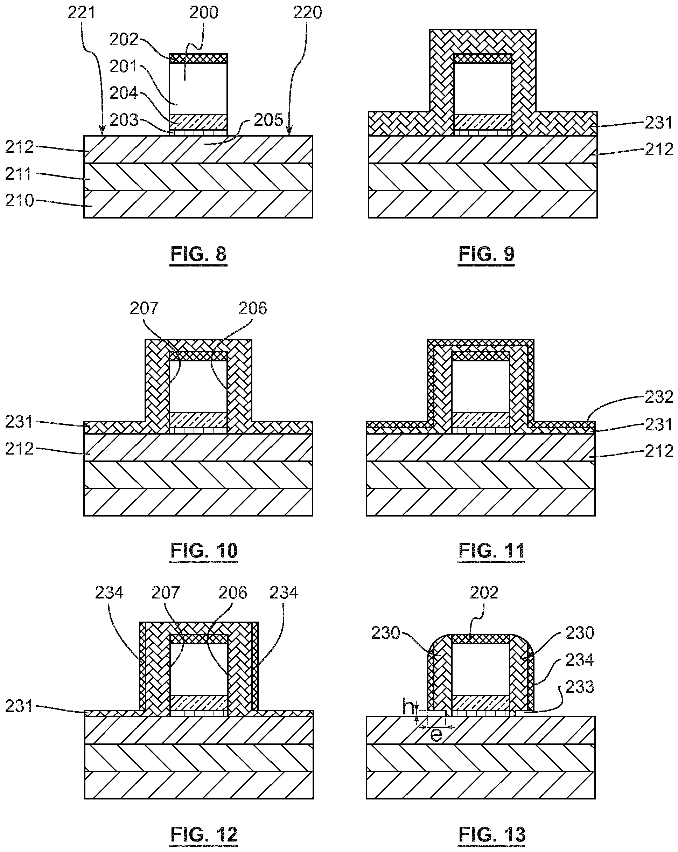

Le procédé de réalisation d'espaceurs selon l'invention est illustré par les figures 9 à 14. Le procédé s'applique après que les grilles des transistors aient été formées, c'est-à-dire à partir d'une structure telle que celle illustrée par la figure 8 qui n'est pas différente, dans cet exemple, de celle de la figure 1 déjà décrite. Le procédé de l'invention peut en effet potentiellement se mettre en oeuvre à partir de n'importe quelle structure de transistor MOSFET après que les motifs de grille aient été définis par photolithographie.

Dans la figure 8, utilisé comme exemple typique de point de départ d'une application du procédé de l'invention, on retrouve donc les éléments déjà décrits :
- Les zones de source et de drain, 220 et 221, qui sont globalement désignées zones source/drain puisqu'elles sont très généralement parfaitement symétriques et peuvent jouer l'un ou l'autre rôle en fonction des polarisations électriques qui sont appliquées au transistor.
- La grille 200 est classiquement constituée d'un empilement de couches dont une grande partie est toujours constituée de silicium polycristallin 201. Les couches 203 et 204 constituent l'oxyde de grille comprenant le plus souvent dans les réalisations récentes une couche 204 d'un matériau à haute permittivité relative dit « high-k ». La couche 202 est un masque dur servant à protéger, à ce stade de réalisation, l'empilement des couches de grille sous-jacentes.
- Un canal 205 de conduction entre source et drain va pouvoir se former pour peu qu'une tension appropriée soit appliquée sur la grille 100 développant un champ électrique suffisant au travers des couches diélectriques 203 et 204.
- Comme on l'a vu, une technique couramment utilisée actuellement consiste à fabriquer les circuits intégrés en partant de substrats élaborés de type SOI. On retrouve dans la structure de la figure 8 les couches constituant ce type de substrat. C'est-à-dire : une fine couche superficielle de silicium monocristallin de Germanium ou de Silicium-Germanium 212 reposant sur une couche continue isolante d'oxyde, dite BOX, 211. La couche 210 constitue le corps du substrat SOI.

La figure 9 illustre la première étape du procédé de l'invention au cours duquel on va venir réaliser les espaceurs en une seule série d'étapes contrairement au procédé traditionnel, brièvement décrit dans le chapitre sur l'état de la technique, qui nécessite de mettre en oeuvre deux séries successives d'étapes comprenant chacune : le dépôt du matériau constituant les espaceurs, sa gravure et une croissance épitaxiale des zones source/drain.

Comme montré sur la figure 9, pour la réalisation des espaceurs en une seule étape, on effectue un seul dépôt d'une couche 231 d'un matériau tel que le nitrure de silicium (SiN) sur une épaisseur correspondant à l'épaisseur totale des deux espaceurs obtenus avec le procédé standard. Typiquement, on procède à un dépôt dit « conforme » sur une épaisseur par exemple allant de 20 à 30 nm, de préférence 25 nm. Le dépôt est conforme s'il se fait de façon égale quelle que soit l'orientation des surfaces sur lesquelles il est réalisé. Pour obtenir ce résultat le dépôt est de préférence effectué à l'aide d'un procédé dit PECVD, acronyme de l'anglais « plasma-enhanced chemical vapor déposition », ou encore d'un procédé dit LPCVD, acronyme de l'anglais « low-pressure chemical vapor déposition ». A l'issue de cette étape, comme représenté sur la figure 9, la couche déposée 231 est d'épaisseur sensiblement égale sur les flancs des motifs de grille et sur les parties horizontales, c'est-à-dire celles parallèles au plan du substrat.

Comme montré sur la figure 10 on procède ensuite à une gravure anisotrope de la couche 231, c'est-à-dire à une gravure essentiellement verticale du matériau déposé, gravure qui se fait donc perpendiculairement au plan du substrat et qui ne grave pas, ou très peu, les flancs des motifs de grille 206 et 207. Ce type de gravure est avantageusement réalisé à partir d'un plasma dans un réacteur de gravure de type à couplage capacitif (CCP) ou à couplage inductif (ICP) et de préférence dans un réacteur de ce dernier type. Cette gravure anisotrope est destinée à ramener l'épaisseur de la couche 231 dans les zones périphériques entourant la grille 200 jusqu'à une valeur correspondant à l'épaisseur (par exemple entre 10 et 15 nm) du premier dépôt du matériau constituant les espaceurs du procédé conventionnel au cours duquel on forme ceux-ci en deux séries d'étapes comme on l'a vu ci-dessus. Les conditions d'une telle gravure anisotrope sont par exemple celles-ci pour un réacteur à couplage inductif: pression = 5 milli Torr ; puissance de la source = 300 Watts ; tension de polarisation = 65 Volts ; débit de trifluorométhane (CHF3) = 30 sccm (centimètres cube par minute) ; débit d'hélium (He) = 220 sccm ; température du porte-substrat (par exemple électrostatique) = 110°C. Dans ces conditions la vitesse de gravure du nitrure de silicium, le matériau standard utilisé pour la formation des espaceurs, est alors de l'ordre de 32 nm par minute.

La figure 11 illustre le résultat de l'étape suivante au cours de laquelle on procède à une oxydation en surface 232 de la couche 231 du matériau destiné à former les espaceurs. Cette opération est effectuée avantageusement de manière isotrope à partir d'un plasma par exemple dans les conditions suivantes: pression = 10 milli Torr ; puissance de la source = 1000 Watts; débit d'oxygène (O2) = 200 sccm ; température du porte-substrat = 60°C. Cette oxydation est de préférence produite dans le même réacteur que celui de la gravure anisotrope. De manière alternative, la couche 232 d'oxyde ou d'un autre matériau (tel le nitrure de Silicium Germanium ou un autre matériau avec du Germanium, avec de préférence un taux de Germanium de 15 à 40%, ou un matériau carboné ou du SiO2 ou un autre oxyde) peut être obtenue par dépôt. L'épaisseur ainsi produite peut être comprise entre 2 et 10 nm de préférence 7 nm.

La figure 12 montre le résultat de l'étape suivante à l'issue de laquelle on ne laisse en place la couche oxydée 232 que sur les flancs des motifs de grille. Ce résultat est obtenu à l'aide d'une opération de gravure verticale très anisotrope dite de « breakthrough » qui est pratiquée par exemple dans un plasma d'argon (Ar) ou de tétra-fluorure de carbone (CF4) et qui grave essentiellement toutes les surfaces oxydées parallèles au plan du substrat. En laissant au moins en partie en place les surfaces oxydées non parallèles au substrat au niveau des flancs 205, 206.

La figure 13 montre le résultat de l'étape de gravure latérale des parties du matériau formant les espaceurs qui ont été désoxydées à l'étape précédente. Cette gravure est sélective vis-à-vis de la couche semi-conductrice 212 sous-jacente et aussi vis-à-vis de la couche oxydée restante 234 qui ne sont donc pas gravées de façon significative au cours de cette opération. Cette étape assure un enlèvement de la couche 231 au-dessus de la couche 212, en dehors de l'espace occupé par la grille et les espaceurs. Typiquement, il s'agit de la portion de la couche 231 orientée parallèlement à la face du substrat, horizontalement dans le cas des figures, soit encore la zone périphérique expliquée précédemment. Cette étape suit la gravure de la couche 232 et n'est pas simultanée, de sorte à assurer une sélectivité différente des deux gravures. Cette étape de gravure de la partie de la couche 231 hors des espaceurs peut s'accompagner, avantageusement simultanément, d'une gravure de ce matériau au niveau des espaceurs (en particulier au droit de la partie résiduelle 234 de la couche superficielle 232. Ainsi, optionnellement, on peut donc obtenir une gravure latérale au pied des espaceurs qui reproduit les formes obtenues avec le procédé standard comme montré sur la figure 7. Plus généralement, on peut donc ajuster un retrait 233 plus ou moins marqué en fonction des conditions de gravure utilisées ou encore ne pas avoir de retrait du tout. La gravure est ici dite latérale, en ce sens qu'elle produit une attaque essentiellement parallèle au substrat du fait de sa sélectivité. Cette gravure est en fait de préférence isotrope. De ce fait, la géométrie du retrait, en particulier du flanc du retrait suivant la hauteur h en figure 13 peut être non rectiligne. En pratique, elle pourra être en arc de cercle.

La gravure latérale peut se pratiquer à partir d'un plasma formé dans les conditions suivantes : pression = 50 à 80 milli Torr ; puissance de la source = 400 Watts ; tension de polarisation = 250 Volts ; débit de fluorométhane (CH3F) = 200 sccm ; débit d'oxygène (O2) = 200 sccm ; débit d'hélium (He) = 120 sccm ; débit de tétrachlorure de silicium (SiCl4) = 5 sccm ; température du porte-substrat = 60°C. La tension de polarisation est pulsée préférentiellement à une fréquence de 500 Hz avec un rapport cyclique de 50%. D'autres conditions de pulsation peuvent être utilisées : 200 Hz/20% ; 900 Hz/90% ; 200 Hz/90%. On peut utiliser le même réacteur que précédemment.

La gravure latérale peut aussi se faire par voie humide dans une solution à base d'acide phosphorique (H3PO4). Dans ce cas la vitesse d'attaque du nitrure de silicium, matériau qui est généralement utilisé pour les espaceurs, est de 4 nm par minute. La température est par exemple comprise entre 80°C et 120°C et de préférence de 100°C. Cette chimie présente une sélectivité infinie par rapport à l'oxyde présent sur les parties résiduelles 234 présentes sur les flancs des espaceurs. Elle est aussi choisie sélective par rapport au matériau de la couche 212.

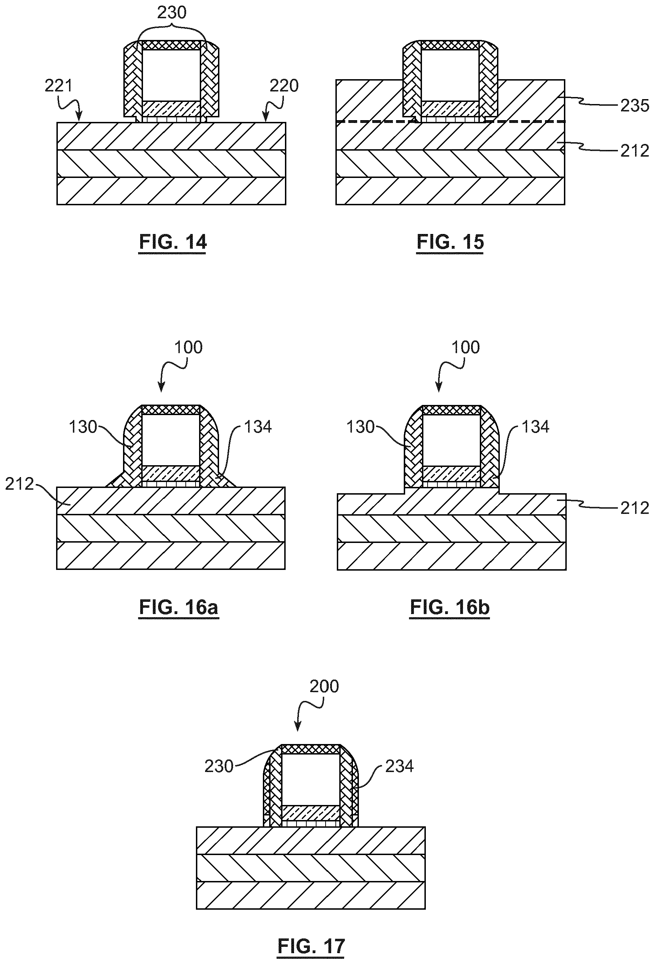

La figure 14 montre une forme des espaceurs 230 que l'on peut obtenir en pratique avec le procédé de l'invention, les parties résiduelles 234 ayant été enlevées, ce qui n'est pas obligatoire mais peut être fait, notamment lors d'une étape de nettoyage, en particulier si le matériau des parties 234 est un oxyde sensible au solution de nettoyage.

En effet, de façon conventionnelle, préalablement à l'opération d'épitaxie, on procède de préférence à un nettoyage humide de la surface de la couche 212 à partir de laquelle la croissance épitaxiale doit se faire. Le nettoyage se fait préférentiellement à l'aide d'une solution à base d'acide fluorhydrique (HF) par exemple diluée à 0,5%, pendant 30 secondes. Ce nettoyage a pour but de retirer les polymères et la couche d'oxyde natif à la surface du semi-conducteur qui est du silicium (Si) ou un composé de silicium et de germanium (SiGe). Dans un autre mode de réalisation, les parties 234 sont maintenues en place.

La figure 15 illustre l'étape de croissance épitaxiale sélective 235 des zones de source et de drain qui est effectuée ensuite. Comme on l'a vu cette opération est effectuée une seule fois avec le procédé de l'invention alors qu'elle doit être répétée une seconde fois quand on utilise le procédé standard de formation des espaceurs.

On fait croître une couche épitaxiale 235 d'une épaisseur par exemple équivalente à celle qui est obtenue avec le procédé standard à l'issue de la seconde série d'étapes de formation des espaceurs. Pour la formation des zones de source et de drain on pourra procéder à un dopage in-situ de ces zones, c'est-à-dire dans le réacteur épitaxial lui-même en y introduisant sous forme gazeuse les espèces dopantes nécessaires comme le bore (dopage de type P) ou l'arsenic (dopage de type N). Optionnellement, si on n'a pas recours à un dopage in-situ, on pourra procéder après formation de la couche épitaxiale à une implantation des espèces dopantes dans un implanteur.

Dans une variante de mise en oeuvre de l'invention le matériau constituant les espaceurs pourra avantageusement être un matériau à plus faible permittivité relative (Low-k) que le nitrure de silicium qui est traditionnellement utilisé ceci afin de réduire les capacités parasites du transistor (entre drain/source d'une part et la grille d'autre part).

La figure 16a illustre un problème qui se produit couramment avec le procédé standard de réalisation des espaceurs où il est difficile de contrôler la gravure du premier espaceur sans endommager la fine couche 212 superficielle de semi-conducteur du substrat (un tel endommagement est illustré en figure 16b). En voulant éviter d'endommager cette couche on forme souvent d'une façon très indésirable des « pieds » 134 au bas des premiers espaceurs.

Un autre problème mentionné ci-dessus du procédé standard de formation des espaceurs où l'on vient, lors d'une gravure trop forte des premiers espaceurs, endommager, comme en figure 16b, la fine couche 212 de semi-conducteur ce qui ne permet plus ensuite de procéder à une épitaxie sans défaut des zones de source et de drain. Ainsi, le procédé standard implique soit une mauvaise géométrie du pied de l'espaceur, soit une détérioration de la couche du matériau semi-conducteur servant de base à l'épitaxie.

Le procédé de l'invention permet de s'affranchir de ces problèmes. Comme montré sur la figure 17 il n'y a plus formation de pieds car on peut régler les paramètres du plasma de gravure, notamment le temps de gravure, sans endommager la couche de semi-conducteur 212, couche à partir de laquelle on va pouvoir procéder à une épitaxie des zones de source et de drain sans défaut.

## Revendications

1. Procédé de réalisation d'espaceurs (230) au niveau de flancs (206,207) d'une grille (200) de transistor dans lequel la grille est située au-dessus d'une couche d'un matériau semi-conducteur (212), le procédé comprenant successivement les étapes suivantes :
- formation d'une couche diélectrique (231) qui recouvre la grille (200) et au moins une zone périphérique (220, 221) de la couche de matériau semi-conducteur (212) entourant la grille (200) ;
- gravure anisotrope de la couche diélectrique (231) configurée pour enlever partiellement la couche diélectrique (231) au niveau de la zone périphérique (220, 221) tout en préservant la couche diélectrique (231) au niveau des flancs (206,207) ;
- puis, après la gravure anisotrope, formation d'une couche superficielle (232) recouvrant la couche diélectrique (231) ;
- gravure partielle de la couche superficielle (232) configurée pour enlever totalement la couche superficielle (232) au niveau de la zone périphérique (220, 221) tout en préservant une partie résiduelle (234) de la couche superficielle (232) au niveau des flancs (206,207) et tout en préservant au moins en partie la couche diélectrique (231) au niveau de la zone périphérique (220, 221);
- puis, après la gravure partielle, gravure de la couche diélectrique (231) de manière sélective par rapport à la partie résiduelle (234) de la couche superficielle (232) et par rapport à la couche de matériau semi-conducteur (212).

2. Procédé selon la revendication 1 dans lequel la formation de la couche superficielle (232) comprend une modification du matériau d'une partie seulement de l'épaisseur de la couche diélectrique (231).

3. Procédé selon la revendication 2 dans lequel la modification est une oxydation.

4. Procédé selon la revendication 3 dans lequel l'oxydation est réalisée de manière conforme au niveau des flancs (206,207) et de la zone périphérique (220, 221).

5. Procédé selon l'une des revendications 3 ou 4 dans lequel l'oxydation est réalisée à partir d'un plasma.

6. Procédé selon la revendication 5 dans lequel on utilise un plasma d'oxygène dans lequel l'énergie des ions est comprise entre 8 et 13 eV, de préférence 10 eV.

7. Procédé selon la revendication 1 dans lequel la formation de la couche superficielle (232) comprend un dépôt d'une couche de matériau au-dessus de la couche diélectrique (231).

8. Procédé selon la revendication 7 dans lequel le matériau de la couche de matériau au-dessus de la couche diélectrique (231) est choisi parmi : un matériau comprenant du carbone, le dioxyde de Silicium (SiO2), un matériau contenant du Germanium

9. Procédé selon l'une des revendications précédentes dans lequel la gravure partielle de la couche superficielle (232) est une gravure opérée à partir d'un plasma, et dans lequel la gravure partielle de la couche superficielle (232) est une gravure anisotrope configurée pour attaquer la couche superficielle (232) au niveau de la zone périphérique (220, 221) tout en n'attaquant pas ou en attaquant moins la couche superficielle (232) au niveau de la grille (200).

10. Procédé selon la revendication 9 dans lequel la gravure anisotrope est réalisée avec un plasma d'argon ou de tétrafluorure de carbone dans lequel l'énergie des ions est comprise entre 8 et 13 eV, de préférence 10 eV.

11. Procédé selon l'une des revendications précédentes dans lequel la gravure de la couche diélectrique (231) est opérée à partir d'un plasma.

12. Procédé selon la revendication précédente en combinaison avec l'une des revendications 9 ou 10 dans lequel on opère la gravure anisotrope puis la gravure de la couche diélectrique (231) dans un même réacteur.

13. Procédé selon l'une des revendications 1 à 10 dans lequel ladite gravure de la couche diélectrique (231) de manière sélective est opérée par voie humide.

14. Procédé selon l'une des revendications précédentes dans lequel ladite gravure de la couche diélectrique (231) de manière sélective est configurée pour attaquer partiellement la couche diélectrique (231) dans une zone de pied de grille située en dessous de la partie résiduelle (234) en direction du flanc de la grille (206,207), de sorte à former un retrait (233).

15. Procédé selon la revendication 14 dans lequel le retrait (233) a une hauteur comprise entre 5 et 30 nm, et de préférence entre 10 et 15 nm.

16. Procédé selon la revendication 14 ou 15 dans lequel le retrait (233) a une largeur comprise entre 5 et 10 nm et/ou a une largeur de grandeur inférieure à celle de la hauteur du retrait.

17. Procédé selon l'une des revendications 1 à 13 dans lequel la gravure de la couche diélectrique (231) est configurée pour former un bord droit dans la couche diélectrique (231) suivant l'épaisseur de ladite couche diélectrique en alignement avec la partie résiduelle (234).

18. Procédé selon l'une des revendications précédentes, dans lequel on utilise comme couche d'un matériau semi-conducteur (212) une couche superficielle d'une plaque de silicium sur isolant totalement déplétée (FD-SOI).

19. Procédé de réalisation d'un transistor dans lequel la grille est située au-dessus d'une couche d'un matériau semi-conducteur (212), ledit procédé comprenant la réalisation d'espaceurs (230) suivant le procédé selon l'une quelconques des revendications précédentes.

20. Procédé selon la revendication précédente, comprenant la réalisation de zones de source et de drain avec une croissance par épitaxie sur la couche de matériau semi-conducteur (212).

## Patentansprüche

1. Verfahren zum Ausführen von Abstandshaltern (230) im Bereich von Flanken (206, 207) eines Transistor-Gates (200), wobei das Gate über einer Schicht aus einem Halbleitermaterial (212) liegt, wobei das Verfahren nacheinander die folgenden Schritte umfasst:
- Bilden einer dielektrischen Schicht (231), die das Gate (200) und mindestens eine Randzone (220, 221) der Halbleitermaterialschicht (212) bedeckt, die das Gate (200) umgibt;
- anisotropes Ätzen der dielektrischen Schicht (231), das dafür konfiguriert ist, die dielektrische Schicht (231) im Bereich der Randzone (220, 221) teilweise zu entfernen, während gleichzeitig die dielektrische Schicht (231) im Bereich der Flanken (206, 207) beibehalten wird;
- und anschließend, nach dem anisotropen Ätzen, Bilden einer Oberflächenschicht (232), die die dielektrische Schicht (231) bedeckt;
- teilweises Ätzen der Oberflächenschicht (232), das dafür konfiguriert ist, die Oberflächenschicht (232) im Bereich der Randzone (220, 221) vollständig zu entfernen, während gleichzeitig ein Restteil (234) der Oberflächenschicht (232) im Bereich der Flanken (206, 207) beibehalten wird, und während gleichzeitig die dielektrische Schicht (231) im Bereich der Randzone (220, 221) mindestens zum Teil beibehalten wird;
- und anschließend, nach dem teilweisen Ätzen, Ätzen der dielektrischen Schicht (231) selektiv in Bezug auf den Restteil (234) der Oberflächenschicht (232) und in Bezug auf die Halbleitermaterialschicht (212).

2. Verfahren nach Anspruch 1, wobei das Bilden der Oberflächenschicht (232) eine Veränderung des Materials nur eines Teils der Dicke der dielektrischen Schicht (231) umfasst.

3. Verfahren nach Anspruch 2, wobei die Veränderung eine Oxidation ist.

4. Verfahren nach Anspruch 3, wobei die Oxidation im Bereich der Flanken (206, 207) und der Randzone (220, 221) in übereinstimmender Weise ausgeführt wird.

5. Verfahren nach einem der Ansprüche 3 oder 4, wobei die Oxidation auf Grundlage eines Plasmas ausgeführt wird.

6. Verfahren nach Anspruch 5, wobei ein Sauerstoffplasma verwendet wird, wobei die Energie der Ionen im Bereich zwischen 8 und 13 eV, vorzugsweise 10 eV beträgt.

7. Verfahren nach Anspruch 1, wobei das Bilden der Oberflächenschicht (232) ein Abscheiden einer Materialschicht über der dielektrischen Schicht (231) umfasst.

8. Verfahren nach Anspruch 7, wobei das Material der Materialschicht über der dielektrischen Schicht (231) ausgewählt ist aus: einem Material, das Kohlenstoff umfasst, Siliziumdioxid (SiO2), einem Material, das Germanium umfasst

9. Verfahren nach einem der vorstehenden Ansprüche, wobei das teilweise Ätzen der Oberflächenschicht (232) ein Ätzen ist, das auf Grundlage eines Plasmas betrieben wird, und wobei das teilweise Ätzen der Oberflächenschicht (232) ein anisotropes Ätzen ist, das dafür konfiguriert ist, die Oberflächenschicht (232) im Bereich der Randzone (220, 221) anzugreifen, während gleichzeitig die Oberflächenschicht (232) im Bereich des Gates (200) nicht angegriffen oder weniger angegriffen wird.

10. Verfahren nach Anspruch 9, wobei das anisotrope Ätzen mit einem Argonplasma oder Tetrafluorkohlenstoff ausgeführt wird, wobei die Energie der Ionen im Bereich zwischen 8 und 13 eV, vorzugsweise 10 eV beträgt.

11. Verfahren nach einem der vorstehenden Ansprüche, wobei das Ätzen der dielektrischen Schicht (231) auf Grundlage eines Plasmas betrieben wird.

12. Verfahren nach dem vorstehenden Anspruch in Kombination mit einem der Ansprüche 9 oder 10, wobei das anisotrope Ätzen und anschließend das Ätzen der dielektrischen Schicht (231) in ein und demselben Reaktor betrieben wird.

13. Verfahren nach einem der Ansprüche 1 bis 10, wobei das selektive Ätzen der dielektrischen Schicht (231) im Nassverfahren betrieben wird.

14. Verfahren nach einem der vorstehenden Ansprüche, wobei das selektive Ätzen der dielektrischen Schicht (231) dafür konfiguriert ist, die dielektrische Schicht (231) in einer Gate-Fußzone, die unter dem Restteil (243) liegt, in Richtung der Flanke des Gates (206, 207) teilweise anzugreifen, um eine Einsenkung (233) zu bilden.

15. Verfahren nach Anspruch 14, wobei die Einsenkung (233) eine Höhe im Bereich zwischen 5 und 30 nm, und vorzugsweise zwischen 10 und 15 nm aufweist.

16. Verfahren nach Anspruch 14 oder 15, wobei die Einsenkung (233) eine Breite im Bereich zwischen 5 und 10 nm aufweist, und/oder eine Breite von kleinerer Größe als derjenigen der Höhe der Einsenkung aufweist.

17. Verfahren nach einem der Ansprüche 1 bis 13, wobei das Ätzen der dielektrischen Schicht (231) dafür konfiguriert ist, entlang der Dicke der dielektrischen Schicht in Ausrichtung zum Restteil (234) eine gerade Kante in der dielektrischen Schicht (231) zu bilden.

18. Verfahren nach einem der vorstehenden Ansprüche, wobei als Schicht aus einem Halbleitermaterial (212) eine Oberflächenschicht einer vollständig verarmten Silizium-auf-Isolator-Platte (FD-SOI) verwendet wird.

19. Verfahren zum Ausführen eines Transistors, wobei das Gate über einer Schicht aus einem Halbleitermaterial (212) liegt, wobei das Verfahren das Ausführen von Abstandshaltern (230) gemäß dem Verfahren nach einem der vorstehenden Ansprüche umfasst.

20. Verfahren nach dem vorstehenden Anspruch, das das Ausführen von Quellen- und Senkenzonen mit einem epitaktischen Aufwachsen auf der Halbleitermaterialschicht (212) umfasst.

## Claims

1. Method for producing spacers (230) at the level of edges (206, 207) of a transistor gate (200), wherein the gate is located above a layer of a semi-conductive material (212), the method successively comprising the following steps:
- forming a dielectric layer (231) which covers the gate (200) and at least one peripheral zone (220, 221) of the semi-conductive material layer (212) surrounding the gate (200);
- anisotropic etching the dielectric layer (231) configured to partially remove the dielectric layer (231) at the level of the peripheral zone (220, 221) while preserving the dielectric layer (231) at the level of the edges (206, 207);
- then, after the anisotropic etching,
forming a superficial layer (232) covering the dielectric layer (231);
- partial etching of the superficial layer (232) configured to totally remove the superficial layer (232) at the level of the peripheral zone (220, 221) while preserving a residual portion (234) of the superficial layer (232) at the level of the edges (206, 207) and while preserving at least partially the dielectric layer (231) at the level of the peripheral zone (220, 221);
- then, after the partial etching, etching of the dielectric layer (231) selectively with respect to the residual portion (234) of the superficial layer (232) and with respect to the semi-conductive material layer (212).

2. Method according to claim 1, wherein the formation of the superficial layer (232) comprises a modification of the material of only one portion of the thickness of the dielectric layer (231).

3. Method according to claim 2, wherein the modification is an oxidation.

4. Method according to claim 3, wherein the oxidation is carried out according to the level of the edges (206, 207) and of the peripheral zone (220, 221).

5. Method according to one of claims 3 or 4, wherein the oxidation is carried out from a plasma.

6. Method according to claim 5, wherein an oxygen plasma is used, wherein the energy from the ions is of between 8 and 13eV, preferably 10eV.

7. Method according to claim 1, wherein the formation of the superficial layer (232) comprises a deposition of a material layer above the dielectric layer (231).

8. Method according to claim 7, wherein the material of the material layer above the dielectric layer (231) is selected from among: a material comprising carbon, silicon dioxide (SiO₂), a material containing germanium.

9. Method according to one of the preceding claims, wherein the partial etching of the superficial layer (232) is an etching carried out from a plasma and wherein the partial etching of the superficial layer (232) is an anisotropic etching configured to attack the superficial layer (232) at the level of the peripheral zone (220, 221) while not attacking or attacking the superficial layer (232) less at the level of the gate (200).

10. Method according to claim 9, wherein the anisotropic etching is carried out with an argon or carbon tetrafluoride plasma, wherein the energy from the ions is of between 8 and 13eV, preferably 10eV.

11. Method according to one of the preceding claims, wherein the etching of the dielectric layer (231) is carried out from a plasma.

12. Method according to the preceding claim combined with one of claims 9 or 10, wherein the anisotropic etching is carried out, then the etching of the dielectric layer (231) in one same reactor.

13. Method according to one of claims 1 to 10, wherein said etching of the dielectric layer (231) selectively is carried out wet.

14. Method according to one of the preceding claims, wherein said etching of the dielectric layer (231) selectively is configured to partially attack the dielectric layer (231) in a gate base zone located below the residual portion (234) in the direction of the edge of the gate (206, 207), so as to form an indentation (233).

15. Method according to claim 14, wherein the indentation (233) has a height of between 5 and 30nm, and preferably between 10 and 15nm.

16. Method according to claim 14 or 15, wherein the indentation (233) has a width of between 5 and 10nm and/or has a width size of less than that of the height of the indentation.

17. Method according to one of claims 1 to 13, wherein the etching of the dielectric layer (231) is configured to form a straight edge in the dielectric layer (231) according to the thickness of said dielectric layer by aligning with the residual portion (234).

18. Method according to one of the preceding claims, wherein a totally depleted superficial layer of a silicon on insulator plate (FD-SOI) is used as layer of a semi-conductive material (212).

19. Method for producing a transistor, wherein the gate is located above a layer of a semi-conductive material (212), said method comprising the production of spacers (230) according to the method according to any one of the preceding claims.

20. Method according to the preceding claim, comprising the production of source and drain zones with an epitaxial growth on the semi-conductive material layer (212).
